# EUROPÄISCHE PATENTSCHRIFT

(11) **EP 1 850 645 B1**
(45) Veröffentlichungstag und Bekanntmachung des Hinweises auf die Patenterteilung: **14.05.2014**
(21) Anmeldenummer: 07008401.7
(22) Anmeldetag: 25.04.2007
(51) Int. Cl.: H05K 1/18, H05K 1/14, H05K 3/32, H05K 1/02

(54) **Baugruppenaufbau**
Module structure
Construction de composants

(30) Priorität: 28.04.2006 DE 102006021023
(43) Veröffentlichungstag der Anmeldung: 31.10.2007
(73) Patentinhaber: Würth Elektronik GmbH & Co. KG, 74676 Niedernhall (DE)
(72) Erfinder: Park , Heyje, 98131 Lindau (DE); Kosteznick , Dr. Jan, Kirchberg (DE)
(74) Vertreter: Richardt Patentanwälte PartG mbB

(56) Entgegenhaltungen:
- EP-A- 0 297 236
- EP-A- 1 691 591
- DE-A1- 4 022 829
- DE-A1- 4 218 883
- DE-A1- 19 650 048
- DE-B3- 10 252 308
- US-A- 5 426 263

## Beschreibung

Die Erfindung betrifft einen Baugruppenaufbau elektronischer Bauelemente und ein Verfahren zum Herstellen eines solchen Baugruppenaufbaus.

Es ist bekannt, dass man aktive wie auch passive Bauelemente fest in Schaltungsträgeraufbauten einlaminiert. Dies stellt neben einem hohen Fertigungsaufwand ebenfalls einen sehr kostenintensiven Integrationsschritt dar. Diese Vorgehensweise setzt sehr hohe Ausbeuten und Fertigungstiefen voraus.

Es ist weiterhin bekannt, dass man zur Signalübertragung und Signalvermittlung in Leiterplatten optische Wellenleiter verwenden kann, die beispielsweise fest in die Schaltungsträger laminiert werden. Dies stellt einen hohen Aufwand bei der Herstellung dar.

Darüberhinaus stellt sich die Problematik, dass einige Materialien und Aufbauten (wie z. B. hydraulische, pneumatische, sensorische), sich mit dem Behandlungsverfahren der Leiterplatten schlecht vertragen. Dies gilt beispielsweise für die bei Lötprozessen erforderlichen hohen Temperaturen.

Es ist bereits eine tragbare Speicherkarte bekannt, bei der der elektronische Baustein innerhalb einer Ausnehmung der Karte angeordnet und mit den Leiterbahnen der Karte über Anschlussdrähte verbunden ist, die mit den Leiterbahnen der Karte verlötet sind. Die gesamten elektronischen Funktionen sind auf dem Baustein, nicht auf der Karte angeordnet (DE 40 22829).

Ebenfalls bekannt ist eine Leiterplatte mit einer Aussparung, an deren Rändern Einbuchtungen vorhanden sind. In die Aussparung kann aus einer Richtung quer zur Ebene der Leiterplatte ein Bauteil eingesetzt werden, das an seinen Kanten Anschlussdrähte aufweist. Diese Anschlussdrähte liegen nach dem Einsetzen des Bauteils federnd an den Wänden der Einbuchtungen an, um das Bauteil während des Lötvorgangs zu halten (EP 0 297 236). Das Einsetzen des Bauteils geschieht gleichzeitig mit dem bestücken der Leiterplatte. Anschließend wird durch eine Verlötung die Schaltung gebildet.

Weiter ist ein Verfahren zur Herstellung einer Halberzeugnisleiterplatte bekannt wodurch eine bessere Ausnützung der mit Leitermustern zu versehenden Flächen von Leiterplatten bei extrem flacher Bauweise erreicht werden kann. Dies wird dadurch realisiert, dass zur Stromversorgung und/oder zur Spannungsversorgung vorgesehene Batterie- oder Akkuelemente als Dünnfilm-Batterie- oder Akkuelemente ausgebildet werden, die so bemessen sind, dass sie in mindestens eine Leiterplattenzwischenschicht integriert werden können und in Ausschnitte dieser Leiterplattenzwischenschichten eingebettet werden. (DE 102 52 308 B3)

Nach DE 196 50 048 A 1 ist ein Speicher für benutzerindividuelle Einstelldaten von Fahrzeug-Ausrüstungsteilen bekannt, der demontierbar in einer Fahrzeug-Sicherheitseinrichtung zum Verschließen und/oder Öffnen von Fahrzeugschlössern angeordnet ist. Der Speicher ist hierbei als SIM-Modul-Karte ausgebildet, die einerseits in die Fahrzeug-Sicherheitseinrichtung und andererseits in ein Aufnahmebehältnis einsetzbar ist.

Der Erfindung liegt die Aufgabe zu Grunde, einen Baugruppenaufbau zu ermöglichen, bei dem diese Nachteile nicht mehr auftreten.

Zur Lösung dieser Aufgabe schlägt die Erfindung einen Baugruppenaufbau mit den im Anspruch 1 genannten Merkmalen vor. Weiterbildungen der Erfindung sind Gegenstand von abhängigen Patentansprüchen. Darüberhinaus schlägt die Erfindung einen Baugruppenaufbau mit den in Anspruch 16 offenbarten Merkmalen vor.

Die Erfindung geht also so vor, dass sie einerseits einen Schaltungsträger mit den für Schaltungsträger geeigneten Methoden und Verfahren herstellt, ohne dabei Rücksicht nehmen zu müssen auf die Besonderheiten von Materialien oder Vorgängen, die gegenüber den Vorgängen bei dem Funktionsmodul kritisch zu sehen sind. Ebenso können die Funktionsmodule hergestellt werden, ohne auf die Besonderheiten bei der Fertigung der Schaltungsträger Rücksicht zu nehmen. Das Ausbilden einer Ausnehmung in dem Schaltungsträger ist ein relativ einfacher Vorgang. Anschliessend können, wenn beide Elemente des Baugruppenaufbaus fertig gestellt sind, eventuell auch getestet sind, die beiden Elemente zusammengefügt werden. Damit entsteht eine Baugruppe, bei der das Funktionsmodul von der Funktion und von der Anordnung her ein Teil der Baugruppe ist, obwohl es getrennt hergestellt wurde.

Dieser Gedanke ist bei der Herstellung, der Montage und Demontage von mechanischen, elektrischen, optischen sowie fluidischen Komponenten, Halbzeugen und deren Kombinationen anwendbar. Dazu zählen auch Energiespeicher sowie Energie erzeugende und Energie liefernde Module, beispielsweise Brennstoffzellen.

In Weiterbildung der Erfindung ist auch vorgesehen, dass das Funktionsmodul aus der Ausnehmung herausnehmbar ist, beispielsweise dann, wenn man eine andere Funktion mit der Baugruppe verwirklichen will oder muss.

In Weiterbildung der Erfindung kann vorgesehen sein, dass durch das Einsetzen oder Einschieben des Funktionsmoduls in die Ausnehmung eine Funktionsverbindung herstellbar ist, beispielsweise in Form einer Kontaktierung, bei der es sich nicht nur um eine elektrische Kontaktierung, sondern auch eine optische Kontaktierung handeln kann.

Das Einsetzen geschieht vorzugsweise in Form eines Einschiebens, so dass durch den Schiebevorgang eine Kontaktierung bewirkt werden kann.

Die Erfindung ist nicht auf die eingangs erwähnte Problematik bei den Wellenleitern beschränkt. Es kann vorgesehen sein, dass das Funktionsmodul elektrische Funktionen aufweist, sowohl aktive als auch passive elektrische Funktionen und/oder Komponenten.

Es kann ebenfalls vorgesehen sein, dass das Funktionsmodul Wärme leitende Funktionen aufweist, wobei es sich sowohl um Wärmezufuhr als auch Wärmeabfuhr handeln kann.

Ebenfalls möglich ist es und liegt im Rahmen der Erfindung, dass das Funktionsmodul optische Funktionen aufweist, sowohl optisch leitende, optisch verbindende als auch optisch speichernde Funktionen.

Ebenfalls denkbar ist es, dass das Funktionsmodul auch fluidische beziehungsweise hydraulische Funktionen aufweist.

Damit das Funktionsmodul in eingebautem Zustand dann auch tatsächlich einen einheitlichen Bestandteil der Baugruppe bilden kann, kann ist erfindungsgemäss vorgesehen, dass das Funktionsmodul die Ausnehmung im wesentlichen vollständig ausfüllt. Es kann auch vorgesehen sein, dass die Ausnehmung, in der das Funktionsmodul eingesetzt ist, anschliessend von der Aussenseite her geschlossen wird. Dann ist das Funktionsmodul von aussen her nicht mehr als getrenntes Bauteil erkennbar.

In Weiterbildung der Erfindung kann vorgesehen sein, dass die Ausnehmung und/oder das Funktionsmodul derart ausgebildet beziehungsweise aneinander angepasst sind, dass beim Einschieben des Funktionsmoduls in die Ausnehmung eine Selbstjustage und eine Zentrierung erfolgt. Damit soll sichergestellt werden, dass die korrekte funktionsmässige Verbindung zwischen den Elementen des Funktionsmoduls und des Schaltungsträgers hergestellt wird.

Hierzu kann auch ein Verdrehschutz gehören, mit dem sichergestellt wird, dass das Funktionsmodul nur in der korrekten Position eingeschoben werden kann.

Erfindungsgemäß ist vorgesehen, dass zwischen dem Schaltungsträger beziehungsweise seiner Ausnehmung und dem Funktionsmodul eine Rasteinrichtung vorgesehen ist, um ein sicheres Halten des Funktionsmoduls in der korrekten Einbauposition zu gewährleisten.

Erfindungsgemäss kann in Weiterbildung vorgesehen sein, dass das in die Ausnehmung eingesetzte Funktionsmodul eine Verbindung mit einem weiteren in dem Schaltungsträger oder an dem Schaltungsträger angeordneten Funktionsmodul herstellt.

Erfindungsgemäss kann in Weiterbildung vorgesehen sein, dass das Funktionsmodul Justagemittel zum Ausrichten gegenüber dem Schaltungsträger aufweist. Bei den Justagemitteln kann es sich um Vertiefungen, Vorsprünge oder auch nur um Markierungen handeln, mit deren Hilfe die korrekte Justage erkannt oder auch gesichert werden kann.

In nochmaliger Weiterbildung der Erfindung kann vorgesehen sein, dass ein Funktionsmodul in Ausnehmungen zweier Schaltungsträger einschiebbar ausgebildet ist, so dass es funktionsmässig eine Verbindung zwischen den beiden Schaltungsträgern herstellen kann. Es kann auch vorgesehen sein, dass damit eine mechanische Verbindung gleichzeitig verwirklicht wird.

Bei einem zwei Schaltungsträger verbindenden Funktionsmodul kann es sinnvoll sein, das Funktionsmodul semiflexibel auszubilden.

Das Funktionsmodul kann auch mehrlagig sein, wobei die mehreren Lagen auch unterschiedliche Arten von Funktionen aufweisen können. Beispielsweise können zwei oder mehrere elektrische und/oder optische und/oder mechanische und/oder sensorische und/oder fluidische und/oder pneumatische und/oder hydraulische und/oder magnetische und/oder metallische Lagen vorhanden sein, beispielsweise auch für getrennte Erwärmung verschiedener Komponenten.

Weitere Merkmale, Einzelheiten und Vorzüge der Erfindung ergeben sich aus den Ansprüchen und der folgenden Beschreibung bevorzugter Ausführungsformen der Erfindung sowie anhand der Zeichnung. Hierbei zeigen:
- Figur 1: eine stark vereinfachte perspektivische Darstellung eines Schaltungsträgers mit einer Ausnehmung;
- Figur 2: die Darstellung eines Funktionsmoduls zum Einsetzen in die Ausnehmung des Schaltungsträgers der Figur 1;
- Figur 3: eine abgeänderte Ausführungsform eines Funktionsmoduls;
- Figur 4: ein teilweise flexibles Funktionsmodul;
- Figur 5: einen aus mehreren Lagen aufgebauten Schaltungsträger;
- Figur 6: vereinfacht einen ganz einfachen Schaltungsträger mit einer einseitig offenen Ausnehmung;
- Figur 7: einen Schaltungsträger mit einem eingesetzten Funktionsmodul;
- Figur 8: die vereinfachte Draufsicht auf eine Ausnehmung in einem Schaltungsträger;
- Figur 9: eine der Figur 8 entsprechende Darstellung;
- Figur 10: eine nochmals weitere Darstellung entsprechend Figur 8 und 9;
- Figur 11: eine nochmals weitere Darstellung mit einer Rasteinrichtung;
- Figur 12: die Darstellung eines Schaltungsträgers mit einem eingebauten optischen Element und einem hierzu gehörenden Funktionsmodul;
- Figur 13: die Zusammenfügung zweier Schaltungsträger und sie verbindender Funktionsmodule, und
- Figur 14: schematisch eine weitere Anwendungsmöglichkeit mit einem mehrlagigen Modul.

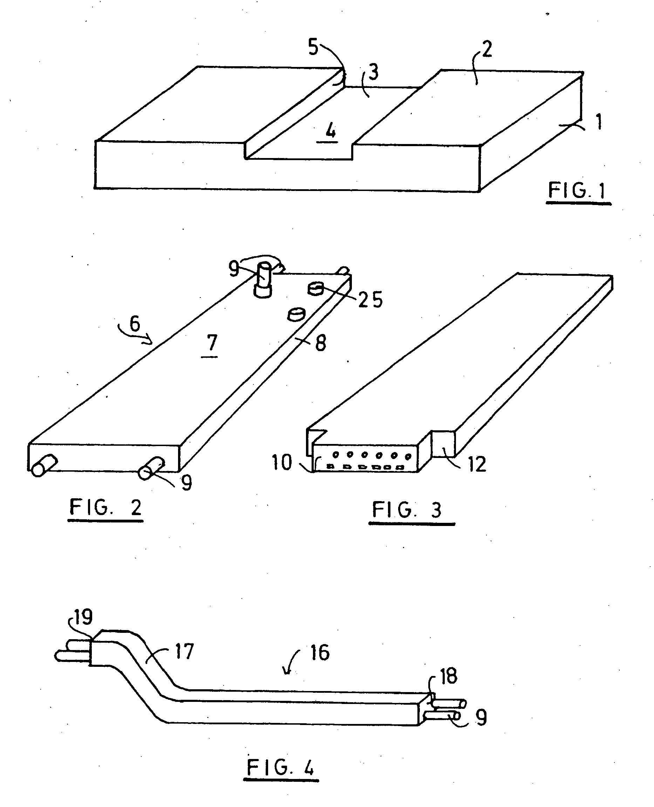

Figur 1 zeigt ganz vereinfacht einen Schaltungsträger 1, der beispielsweise nach Art einer Leiterplatte aufgebaut ist. Er enthält Leiterbahnen und Anschlussstellen für elektronische Bauelemente, die nicht dargestellt sind. Von der Oberseite 2 aus ist in dem Schaltungsträger 1 eine Vertiefung 3 eingebracht, die einen ebenen Boden 4 und zwei parallel zueinander verlaufende Seitenwände 5 aufweist. Der Boden 4 verläuft parallel zur Oberseite 2 und der Unterseite des Schaltungsträgers 1. Denkt man sich die Vertiefung 3 oben geschlossen, so bildet sie eine quaderförmiger Ausnehmung.

Die Herstellung dieser eine Ausnehmung bildenden Vertiefung 3 kann beispielsweise durch eine abtragende Bearbeitung von der Oberseite her erfolgen, oder aber auch dadurch, dass auf einer Platte rechts und links der späteren Vertiefung jeweils zwei Einzelelemente aufgetragen werden.

In diese eine Ausnehmung bildende Vertiefung 3 kann nun ein Funktionsmodul 6 eingesetzt werden, wie es beispielsweise in Figur 2 dargestellt ist. Das Funktionsmodul 6 der Figur 2 hat die Form einer flachen Platte mit einer Oberseite 7, einer nicht sichtbaren parallel dazu verlaufenden Unterseite, zwei Seitenwänden 8 und einer vorderen und hinteren Stirnseite. Der Abstand der beiden Seitenwände 8 entspricht dem Abstand der Seitenwände 5 der Vertiefung 3 des Schaltungsträgers der Figur 1. Dadurch lässt sich das Funktionsmodul 6 der Figur 2 in die Vertiefung 3 beispielsweise von der Vorderseite in Figur 1 her einschieben. Das Funktionsmodul 6 kann beispielsweise hochpräzis eingebrachte Führungsstifte 9 aufweisen, die auf der Vorderseite aus der Stirnseite 10 herausragen und zur toleranzarmen Justage des Funktionsmoduls 6 gegenüber dem Schaltungsträger dienen. Das Funktionsmodul 6 kann ebenfalls weitere Führungshilfen 9 aufweisen, die aus der Oberseite 7 herausragen. In zusammengesetztem Zustand verläuft die Oberseite 7 des Funktionsmoduls 6 bündig mit der Oberseite 2 des Schaltungsträgers 1. Die Seitenwände 8 des Funktionsmoduls 6 liegen dicht an den Seitenwänden 5 der Vertiefung 3 an.

Das Funktionsmodul 6 kann mehrlagig sein.

Maßgebend für die Erfindung ist, dass der Schaltungsträger 1 der Figur 1 unabhängig von dem Funktionsmodul 6 der Figur 2 hergestellt wird. Erst dann, wenn der Schaltungsträger 1 fertiggestellt ist, und wenn das Funktionsmodul 6 fertiggestellt ist, werden die beiden Bauelemente zusammengefügt.

Figur 3 zeigt ein weiteres Funktionsmodul 6, bei dem an der in Figur 3 sichtbaren Frontseite 10 rechts und links Einschnitte 12 vorgesehen sind, die dazu dienen, dieses Funktionsmodul 6 in der Ausnehmung zu fixieren. An der in Figur 3 zu sehenden Stirnseite 10 münden beispielsweise optische Wellenleiter oder auch elektrische Leiter aus. Diese können in mehreren Lagen übereinander angeordnet sein, was nicht näher erläutert wird.

Figur 4 zeigt ein Funktionsmodul 16, das stabförmig ausgebildet ist und das in einem mittleren Abschnitt 17 flexibel ausgebildet ist. Dadurch ist es möglich, dass die beiden Stirnflächen 18, 19 auf unterschiedlicher Höhe angeordnet werden können. Ein solches Funktionsmodul 16 kann beispielsweise dazu verwendet werden, zwei Schaltungsträger 1 miteinander funktionsmäßig zu verbinden, indem das eine Ende des Funktionsmoduls 16 in einen Schaltungsträger eingeschoben wird, während das andere Ende für einen zweiten Schaltungsträger gedacht ist.

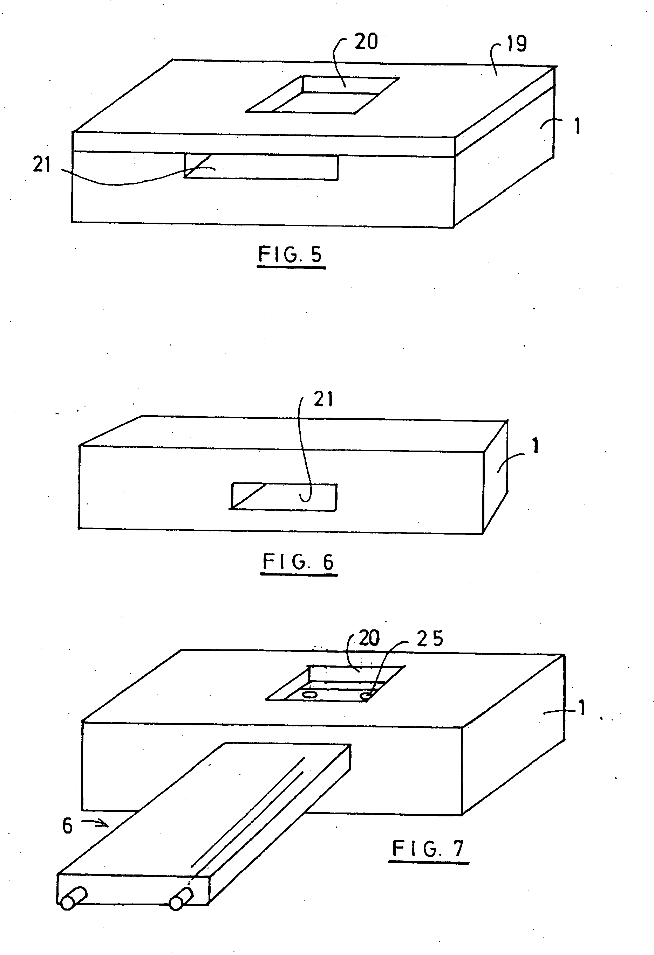

Die Figur 5 zeigt einen Schaltungsträger 1, der zunächst so aussieht wie der Schaltungsträger 1 der Figur 1. Dann ist aber auf die Oberseite 2 eine einen Deckel bildende Platte 19 aufgesetzt, die ein Fenster 20 aufweist. Durch dieses Fenster 20 ist der Zugang zu der Vertiefung 3 möglich, die jetzt durch den Deckel 19 abgedeckt wird. Hier kann ein Funktionsmodul von der Vorderseite her in die Ausnehmung 21 eingeschoben werden. In eingeschobenem Zustand ist das Funktionsmodul durch das Fenster 20 her noch in einem bestimmten Bereich zugänglich, beispielsweise um dort Verbindungen mit den Funktionsteilen des Funktionsmoduls herzustellen.

Figur 6 zeigt einen Schaltungsträger 1, bei dem die Ausnehmung 21 von der Vorderseite her in das Innere führt, beispielsweise auch als Sackloch ausgebildet.

Figur 7 zeigt ein Beispiel, wo in einem Schaltungsträger 1 ein Funktionsmodul 6 eingesetzt ist, dass in seinem in dem Schaltungsträger 1 angeordneten Bereich durch das Fenster 20 her zugänglich ist. Hier können optische Leiter, aber auch fluidische, sensorische, elektrische, mechanische Leiter oder dergleichen, ausmünden oder auch einmünden.

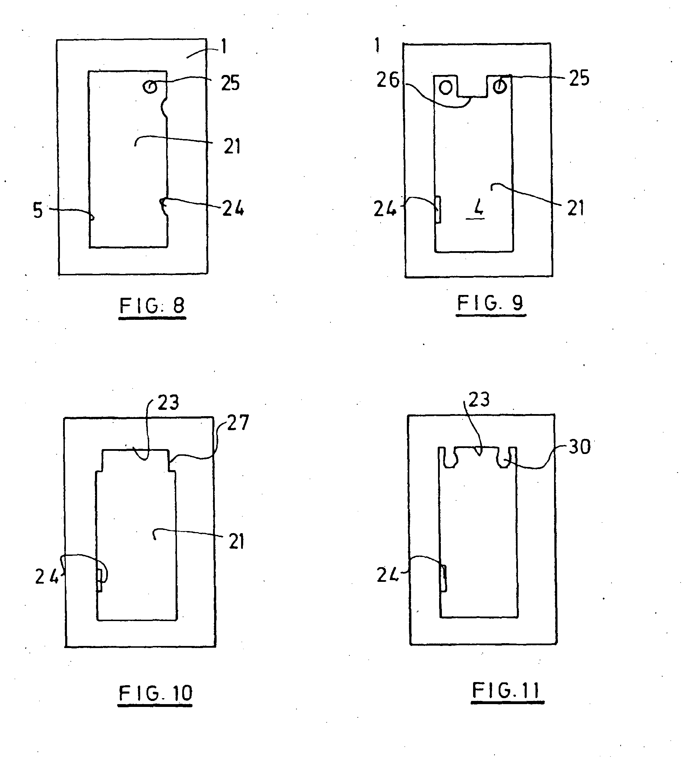

Die Figuren 8 bis 11 zeigen Draufsichten auf die Ausnehmungen in Schaltungsträgern, also beispielsweise von oben in den Figuren 5 und 7.
Die Ausnehmung 21 der Figur 8 enthält, wie bereits bei Figur 1 erwähnt, zwei ebene parallele Seitenwände 5. Sie ist an beiden Stirnseiten durch ebenfalls ebene Seitenwände 23 abgeschlossen. An der in Figur 8 rechten Seitenwand 5 sind zwei Vorsprünge 24 ausgebildet, die sich nicht über die gesamte Höhe der Ausnehmung 21 erstrecken. Diese Vorsprünge 24 wirken mit Nuten in der einen Längsseitenwand 8 eines Funktionsmoduls 6 zusammen. Damit soll erreicht werden, dass das Funktionsmodul 6, das nur in einer Seitenwand 8 eine solche Nut hat, nur in der richtigen Position eingeschoben werden kann. Zur Justage kann eine Öffnung 25 dienen, die mit einer entsprechenden Öffnung oder auch nur einer Markierung in dem Funktionsmodul 6 in Übereinstimmung gebracht werden muss, um dadurch das korrekte Ausgerichtetsein des Funktionsmoduls 6 erkennen zu können.

Bei der Ausnehmung 21 der Figur 9 ist ein solcher Vorsprung 24 an der linken Seitenwand 5 ausgebildet. Die Stirnwand 23 enthält einen nach innen gerichteten Vorsprung 26, der mit einer entsprechenden Kerbe in der Stirnseite des Funktionsmoduls zusammenwirken kann. Es sind zwei Anschlusseinrichtungen 25 in dem Boden 4 der Ausnehmung 21 vorgesehen, die entweder zur Ausrichtung oder auch zur Verbindung zwischen Elementen des Funktionsmoduls und Elementen des Schaltungsträgers 1 dienen können.

Figur 10 zeigt eine weitere Draufsicht auf eine Ausnehmung 21, bei der die Stirnseite 23 an beiden Enden Vorsprünge 27 aufweist, die mit den Einkerbungen 12 der Stirnseite 10 des Funktionsmoduls 6 der Figur 3 zusammen wirken können.

Bei der Ausführungsform der Figur 11 ist an der Stirnseite 23, die der Einschieberichtung entgegengesetzt ist, eine Rasteinrichtung 30 vorgesehen, die zwei Vorsprünge aufweist, die in hinterschnittene Ausnehmungen der entsprechenden Stirnseite 10 eines Funktionsmoduls 6 eingreifen können. Dies bildet eine Art snapin.

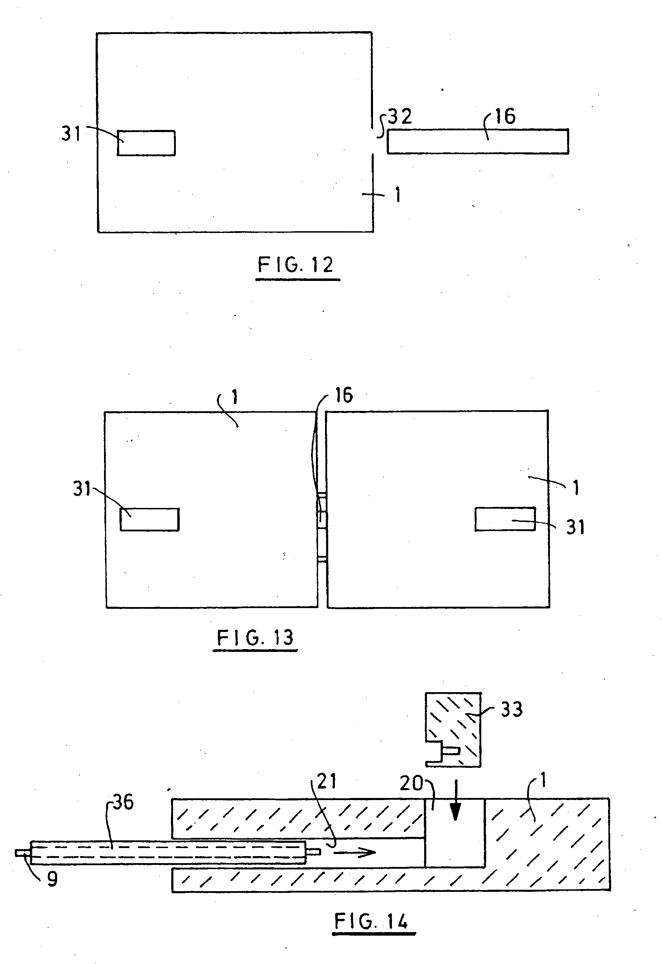

Die Figur 12 zeigt nun ein weiteres Beispiel, wo die Erfindung Anwendung finden kann. In einem Schaltungsträger 1 ist ein Funktionsbaustein 31 angeordnet, beispielsweise fest eingebaut. Ein Funktionsmodul 16 in Form eines Stabes, siehe auch Figur 4, kann nun in eine Öffnung 32 eingeschoben werden, um dann im Inneren des Schaltungsträgers 1 eine Verbindung mit dem Funktionsbaustein 31 herzustellen. Diese Verbindung kann beispielsweise auch eine optische Verbindung sein.

Figur 13 zeigt eine auf der Lösung der Figur 12 aufbauende weitere Lösung. Hier sind zwei Schaltungsträger 1 mit jeweils einem Funktionsbaustein 31 symmetrisch zueinander angeordnet, und ein oder mehrere Funktionsmodule 16 greifen in Ausnehmungen beider Schaltungsträger 1 ein. Dadurch wird mithilfe eines einzigen oder auch mehrerer Funktionsmodule 16 eine Verbindung zwischen zwei Schaltungsträgern 1 hergestellt. Diese Verbindung kann so gestaltet werden, dass sie nicht nur eine funktionsmäßige Verbindung, also eine leitende Verbindung zwischen den beiden Schaltungsträgern herstellt, sondern auch eine mechanische Verbindung.

In Figur 13 wurde dargestellt, wie zwei getrennte Schaltungsträger 1 mithilfe eines oder mehrerer Funktionsmodule 16 funktionsmäßig miteinander verbunden werden können. Es sich aber auch eine andere Anordnung möglich, nämlich die Verbindung zweier Funktionsmodule in einem einzigen Schaltungsträger 1. Dies ist in Figur 14 dargestellt. Figur 14 zeigt stark vereinfacht einen Schnitt durch einen Schaltungsträger 1, der eine wie oben beschriebene Aufnahme 21 zum Einsetzen eines Funktionsmoduls 36 aufweist. Das Funktionsmodul 36 kann beispielsweise so ausgebildet sein, wie dies die Figur 2 zeigt. Es wird in die Ausnehmung 21 in Richtung des eingezeichneten Pfeils eingeschoben.

In die Ausnehmung 21 mündet, ähnlich wie bei der Ausführungsform nach Figur 5 und 7, von oben eine Vertiefung mit einem Fenster 20. In dieses Fenster 20 wird von oben ein zweites Bauelement 33 eingeschoben beziehungsweise eingesetzt, das in seiner der Ausnehmung 21 zugewandten Frontseite eine Verlängerung der Ausnehmung 21 und eine Bohrung zur Aufnahme der Positionierungsstifte 9 aufweist. Es findet also in dem Schaltungsträger 1 eine Verbindung zwischen dem Funktionsmodul 36 und dem weiteren Bauelement 33 statt. Bei dem weiteren Bauelement 33 kann es sich sowohl um einen weiteren Schaltungsträger 1 als auch um ein weiteres Funktionsmodul 6 handeln. Es ist auch denkbar, dass ein solches weiteres Bauelement 33 in einem Fenster 20 eines weiteren darüber angeordneten Schaltungsträgers 1 eingreifen kann.

Das in Figur 14 dargestellte Funktionsmodul 36, das mit dem weiteren Bauelement 33 verbunden wird, kann selbstverständlich auch in Verbindung mit dem Schaltungsträger 1 treten.

Das Funktionsmodul 36 der Figur 14 enthält, durch die gestrichelten Linien dargestellt ist, mehrere Lagen, im dargestellten Beispiel drei Lagen. In den einzelnen Lagen können unterschiedliche Funktionen untergebracht sein, beispielsweise in einer Lage optische Funktionen, während eine andere Lage elektrische Funktionen enthält. Es ist aber auch möglich, dass in allen Lagen die gleichen Funktionen enthalten sind.

## Patentansprüche

1. Baugruppenaufbau elektronischer Bauelemente, mit
1.1 einem Schaltungsträger (1), der als Leiterplatte ausgebildet ist, wobei der Schaltungsträger Leiterbahnen und Anschlussstellen für die elektronischen Bauelemente enthält,
1.2 mindestens einer in dem Schaltungsträger (1) ausgebildeten Ausnehmung (3, 21), wobei die Ausnehmung als Sackloch ausgebildet ist,
1.3 einem in die Ausnehmung (3, 21) einsetzbaren Funktionsmodul (6, 16), das
1.4 getrennt von dem Schaltungsträger (1) herstellbar ist und
1.5 nach dem Einsetzen in die Ausnehmung (3, 21) funktioneller Teil der Baugruppe ist, wobei
1.6 das Funktionsmodul (6, 16) die Ausnehmung (3, 21) im wesentlichen vollständig ausfüllt,
1.7 durch das Einsetzen des Funktionsmoduls (6, 16) in die Ausnehmung (3, 21) eine Funktionsverbindung herstellbar ist
1.8 das Funktionsmodul (6, 16) aus der Ausnehmung (3, 21) herausnehmbar ist,
1.9 das Funktionsmodul (6, 16) elektrische Funktionen aufweist,
1.10 das Funktionsmodul (6, 16, 36) zur Energieversorgung der Baugruppe dient und einen Energiespeicher aufweist, wobei es sich bei dem Energiespeicher um eine Batterie handelt.
1.11 einer Rasteinrichtung zwischen dem Schaltungsträger (1) und dem Funktionsmodul (6, 16).

2. Baugruppenaufbau nach einem der vorhergehenden Ansprüche, bei dem das Funktionsmodul (6, 16) aktive und/oder passive elektrische Funktionen und/oder Komponenten aufweist.

3. Baugruppenaufbau nach einem der vorhergehenden Ansprüche, bei dem das Funktionsmodul (6, 16) Wärme leitende Funktionen aufweist.

4. Baugruppenaufbau nach einem der vorhergehenden Ansprüche, bei dem das Funktionsmodul (6, 16) optische Funktionen aufweist.

5. Baugruppenaufbau nach einem der vorhergehenden Ansprüche, bei dem das Funktionsmodul (6, 16) hydraulische/pneumatische und/oder mechanische aktorische Funktionen, gegebenenfalls auch in Kombination aufweist.

6. Baugruppenaufbau nach einem der vorhergehenden Ansprüche, bei dem die Ausnehmung (3, 21) und das Funktionsmodul (6, 16) derart ausgebildet sind, dass bei Einschieben des Funktionsmoduls (6, 16) in die Ausnehmung (3, 21) eine Selbstjustage und eine Zentrierung erfolgt.

7. Baugruppenaufbau nach einem der vorhergehenden Ansprüche, mit einem Verdrehschutz.

8. Baugruppenaufbau nach einem der vorhergehenden Ansprüche, bei dem bei Einschieben des Funktionsmoduls (6, 16) in die Ausnehmung (3, 21) eine Verbindung mit einem weiteren Funktionsmodul herstellbar ist.

9. Baugruppenaufbau nach einem der vorhergehenden Ansprüche, bei dem das Funktionsmodul (6, 16) Justagemittel zum Ausrichten gegenüber dem Schaltungsträger (1) aufweist.

10. Baugruppenaufbau nach einem der vorhergehenden Ansprüche, bei dem das Funktionsmodul (6, 16) in Ausnehmungen (3, 21) zweier Schaltungsgeräte (1) einschiebbar ausgebildet ist.

11. Baugruppenaufbau nach einem der vorhergehenden Ansprüche, bei dem ein Funktionsmodul (6, 16) zwei Schaltungsträgern (1) zugeordnet ist.

12. Baugruppenaufbau nach einem der vorhergehenden Ansprüche, bei dem das Funktionsmodul (6, 16) semiflexibel ausgebildet ist.

13. Baugruppenaufbau nach einem der vorhergehenden Ansprüche, bei dem das Funktionsmodul (6, 16) austauschbar und/oder updatefähig ist, insbesondere austauschbar gegen ein in seinen Abmessungen und Verbindungen identisches in seinen Funktionen geändertes Funktionsmodul.

14. Baugruppenaufbau nach einem der vorhergehenden Ansprüche, bei dem das Funktionsmodul (6,16) einlagig ausgebildet ist.

15. Baugruppenaufbau nach einem der Ansprüche 1 bis 14, bei dem das Funktionsmodul (36) mehrlagig aufgebaut ist, wobei die mehreren Lagen gleiche oder unterschiedliche Arten von Funktionen aufweisen.

16. Baugruppenaufbau elektronischer Bauelemente, mit 16.1
zumindest einem Schaltungsträger (1), der als Leiterplatte ausgebildet ist, wobei der Schaltungsträger Leiterbahnen und Anschlussstellen für die elektronischen Bauelemente enthält,
16.2 mindestens einer in dem Schaltungsträger (1) ausgebildeten Ausnehmung (3, 21), wobei die Ausnehmung als Sackloch ausgebildet ist,
16.3 zumindest einem Funktionsmodul (6, 16), das in die Ausnehmung (3, 21) einsetzbar ist, und das
16.4 getrennt von dem Schaltungsträger (1) herstellbar ist und
16.5 nach dem Einsetzen in die Ausnehmung (3, 21) funktioneller Teil der Baugruppe ist,
16.6 Führungsstifte (9) aufweist, die auf der Vorderseite aus der Stirnseite (10) des Funktionsmoduls herausragen,
16.7 wobei in die Ausnehmung (3, 21) von oben eine Vertiefung mit einem Fenster (20) mündet,
16.8 und mit einem Bauelement (33), welches in das Fenster (20) von oben eingeschoben ist, wobei das Bauelement (33) in seiner, der Ausnehmung (21) zugewandten Frontseite eine Verlängerung der Ausnehmung (21) und eine Bohrung zur Aufnahme der Positionierungsstifte (9) aufweist, sodass in dem Schaltungsträger (1) eine Verbindung zwischen dem Funktionsmodul (36) und dem Bauelement (33) stattfindet,
16.9 wobei es sich bei dem Bauelement (33) um einen weiteren der Schaltungsträger (1) oder um ein weiteres der Funktionsmodule (6) handelt.

## Claims

1. A module assembly of electronic components, comprising:
1.1 a circuit carrier (1), which is designed as a printed circuit board, wherein the circuit carrier comprises conductive tracks and connecting points for the electronic components;
1.2 at least one recess (3, 21) formed in the circuit carrier (1), the recess being designed as a blind hole;
1.3 a functional module (6, 16), which can be inserted into the recess (3, 21) and which
1.4 can be produced separately from the circuit carrier (1) and
1.5 is a functional part of the module after having been inserted into the recess (3, 21), wherein
1.6 the functional module (6, 16) essentially fills the recess (3, 21) completely;
1.7 a functional connection can be created by inserting the functional module (6, 16) into the recess (3, 21);
1.8 the functional module (6, 16) can be removed from the recess (3, 21);
1.9 the functional module (6, 16) has electrical functions;
1.10 the functional module (6, 16, 36) is used to supply the module with power and comprises an energy store, the energy store being a battery;
1.11 a detent device between the circuit carrier (1) and the functional module (6, 16).

2. A module assembly according to any one of the preceding claims, wherein the functional module (6, 16) includes active and/or passive electrical functions and/or components.

3. A module assembly according to any one of the preceding claims, wherein the functional module (6, 16) includes heat conducting functions.

4. A module assembly according to any one of the preceding claims, wherein the functional module (6, 16) includes optical functions.

5. A module assembly according to any one of the preceding claims, wherein the functional module (6, 16) includes hydraulic / pneumatic and / or mechanical / actuator functions, optionally also in combination.

6. A module assembly according to any one of the preceding claims, wherein the recess (3, 21) and the functional module (6, 16) are designed such that self-adjustment and centering take place when the functional module (6, 16) is inserted into the recess (3, 21).

7. A module assembly according to any one of the preceding claims, comprising an antiturn mechanism.

8. A module assembly according to any one of the preceding claims, wherein a connection can be created to a further functional module during the insertion of the functional module (6, 16) into the recess (3, 21).

9. A module assembly according to any one of the preceding claims, wherein the functional module (6, 16) comprises adjustment means for alignment in relation to the circuit carrier (1).

10. A module assembly according to any one of the preceding claims, wherein the functional module (6, 16) is designed to be insertable into recesses (3, 21) of two switching devices (1).

11. A module assembly according to any one of the preceding claims, wherein one functional module (6, 16) is assigned to two circuit carriers (1).

12. A module assembly according to any one of the preceding claims, wherein the functional module (6, 16) is designed to be semi-flexible.

13. A module assembly according to any one of the preceding claims, wherein the functional module (6, 16) is replaceable and/or updatable, in particular replaceable against a functional module that has identical dimensions and connections and modified functions.

14. A module assembly according to any one of the preceding claims, wherein the functional module (6, 16) has a single-layer design.

15. A module assembly according to any one of claims 1 to 14, wherein the functional module (36) has a multi-layer design, the multiple layers having identical or different types of functions.

16. A module assembly of electronic components, comprising:
16.1 at least one circuit carrier (1), which is designed as a printed circuit board, the circuit carrier comprising conductive tracks and connecting points for the electronic components;
16.2 at least one recess (3, 21) formed in the circuit carrier (1), wherein the recess is designed as a blind hole;
16.3 at least one functional module (6, 16), which can be inserted into the recess and which
16.4 can be produced separately from the circuit carrier (1) and
16.5 is a functional part of the module after having been inserted into the recess (3, 21),
16.6 comprises guide pins (9), which protrude on the front from the end face (10) of the functional module;
16.7 wherein a depression having a window (20) opens into the recess (3, 21) from above;
16.8 and comprising a component (33), which is inserted from above into the window (20), wherein the front side of the component (33) facing the recess (21) comprises an extension of the recess (21) and a borehole for accommodating the positioning pins (9), so that a connection is created between the functional module (36) and the component (33) in the circuit carrier (1);
16.9 wherein the component (33) is a further one of the circuit carriers (1) or a further one of the functional modules (6).

## Revendications

1. Construction de module de composants électroniques avec
1.1 un support de circuit (1) conçu comme un circuit imprimé, le support de circuit comprenant des pistes conductrices et des points de raccordement pour les composants électroniques,
1.2 au moins un évidement (3, 21) formé dans le support de circuit (1), l'évidement étant conçu comme un trou borgne,
1.3 un module fonctionnel (6, 16) insérable dans l'évidement (3, 21), lequel
1.4 peut être fabriqué séparément du support de circuit (1) et
1.5 devient une partie fonctionnelle du module après l'insertion dans l'évidement (3, 21), dans laquelle
1.6 le module fonctionnel (6, 16) remplit presque entièrement l'évidement (3, 21),
1.7 une liaison fonctionnelle peut être réalisée par l'insertion du module fonctionnel (6, 16) dans l'évidement (3, 21),
1.8 le module fonctionnel (6, 16) peut être sorti de l'évidement (3, 21),
1.9 le module fonctionnel (6, 10) comporte des fonctions électriques,
1.10 le module fonctionnel (6, 16, 36) sert à alimenter le module en énergie et comporte un accumulateur d'énergie, l'accumulateur d'énergie étant une batterie,
1.11 un dispositif d'encliquetage entre le support de circuit (1) et le module fonctionnel (6, 16).

2. Construction de module selon l'une des revendications précédentes, dans laquelle le module fonctionnel (6, 16) comporte des fonctions et/ou des composants actifs et/ou passifs.

3. Construction de module selon l'une des revendications précédentes, dans laquelle le module fonctionnel (6, 16) comporte des fonctions de conduction thermique.

4. Construction de module selon l'une des revendications précédentes, dans laquelle le module fonctionnel (6, 16) comporte des fonctions optiques.

5. Construction de module selon l'une des revendications précédentes, dans laquelle le module fonctionnel (6, 16) comporte des fonctions hydrauliques/pneumatiques et/ou mécaniques/actoriques, éventuellement combinées.

6. Construction de module selon l'une des revendications précédentes, dans laquelle l'évidement (3, 21) et le module fonctionnel (6, 16) sont conçus de manière à ce que l'insertion du module fonctionnel (6, 16) dans l'évidement (3, 21) entraîne un ajustement automatique et un centrage.

7. Construction de module selon l'une des revendications précédentes, avec une protection anti-rotation.

8. Construction de module selon l'une des revendications précédentes, dans laquelle l'insertion du module fonctionnel (6, 16) dans l'évidement (3, 21) permet d'établir une liaison avec un autre module fonctionnel.

9. Construction de module selon l'une des revendications précédentes, dans lequel le module fonctionnel (6, 16) comporte des moyens d'ajustement pour l'orientation par rapport au support de circuit (1).

10. Construction de module selon l'une des revendications précédentes, dans lequel le module fonctionnel (6, 16) est conçu de façon à pouvoir être inséré dans les évidements (3, 21) de deux appareils de commutation (1).

11. Construction de module selon l'une des revendications précédentes, dans laquelle un module fonctionnel (6, 16) est attribué à deux supports de circuit (1).

12. Construction de module selon l'une des revendications précédentes, dans laquelle le module fonctionnel (6, 16) est conçu semi-flexible.

13. Construction de module selon l'une des revendications précédentes, dans laquelle le module fonctionnel (6, 16) peut être remplacé et/ou actualisé, en particulier remplacé par un module fonctionnel identique quant à ses dimensions et connexions et modifié quant à ses fonctions.

14. Construction de module selon l'une des revendications précédentes, dans laquelle le module fonctionnel (6, 16) est conçu avec une seule couche.

15. Construction de module selon l'une des revendications 1 à 14, dans laquelle le module fonctionnel (36) est construit avec plusieurs couches, les plusieurs couches comportant des types de fonctions identiques ou différents.

16. Construction de module de composants électroniques, avec
16.1 au moins un support de circuit (1) conçu comme un circuit imprimé, le support de circuit comprenant des pistes conductrices et des points de raccordement pour les composants électroniques,
16.2 au moins un évidement (3, 21) formé dans le support de circuit (1), l'évidement étant formé comme un trou borgne,
16.3 au moins un module fonctionnel (6, 16) insérable dans l'évidemment (3, 21), et lequel
16.4 peut être fabriqué séparément du support de circuit (1), et
16.5 devient une partie fonctionnelle du module après l'insertion dans l'évidement (3, 21),
16.6 comporte des tiges de guidage (9) faisant saillie hors du côté frontal (10) du module fonctionnel, du côté avant,
16.7 dans laquelle un renfoncement avec une fenêtre (20) débouche par le haut dans l'évidement (3, 21),
16.8 et avec un composant (33) inséré par le haut dans la fenêtre (20), dans laquelle le composant (33) comporte un prolongement de l'évidement (21) dans son côté frontal tourné vers l'évidement (21), ainsi qu'un perçage pour la réception des tiges de positionnement (9), de manière à établir une connexion entre le module fonctionnel (36) et le composant (33) dans le support de circuit (1),
16.9 dans laquelle le composant (33) est un autre support de circuit (1) ou un autre module fonctionnel (6).
